# EUROPEAN PATENT APPLICATION

(11) **EP 4 729 954 A1**
(43) Date of publication of application: **22.04.2026**
(21) Application number: 25209775.3
(22) Date of filing: 20.10.2025
(51) Int. Cl.: G01R 27/26, G01R 31/28

(54) **SEMICONDUCTOR DEVICE WITH AGING SENSOR SYSTEM AND METHOD THEREFOR**

(30) Priority: 21.10.2024 US 202418921111
(71) Applicant: NXP B.V., 5656 AG Eindhoven (NL)
(72) Inventor: van Soestbergen, Michiel, 5656AG Eindhoven (NL); Hooper, Stephen Ryan, 5656AG Eindhoven (NL); Li, Fengyuan, 5656AG Eindhoven (NL)
(74) Representative: Colaiuda, Antonella

(57) **Abstract**

A semiconductor device apparatus is provided. The apparatus includes a packaged semiconductor device (100) mounted on a substrate (132). The packaged semiconductor device includes a semiconductor die (102) having a controller configured to obtain a measured capacitance of a sensor capacitor (138), an encapsulant (122) encapsulating the semiconductor die, and a first plate (114) of the sensor capacitor formed at a bottom side of the packaged semiconductor device. A second plate (128) of the sensor capacitor is formed at a top side of the substrate.

## Description

### Background

### Field

This disclosure relates generally to semiconductor devices, and more specifically, to semiconductor devices with an aging sensor system and method of forming the same.

### Related Art

Semiconductor devices are often found in a large spectrum of electronic products - from sewing machines to washing machines, from automobiles to cellular telephones, and so on. Many of these semiconductor devices may include sensitive systems and may be produced in high volumes to drive costs down. However, some factors such as aging of components may adversely affect or constrain applications using these semiconductor devices. It is therefore desirable, as technology progresses, to accommodate flexible and less constrained applications of these semiconductor devices while keeping product costs in focus.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified cross-sectional view, an example semiconductor device apparatus having an aging sensor system at a stage of manufacture in accordance with an embodiment.
FIG. 2 illustrates, in a simplified bottom-side-up plan view, the example semiconductor device apparatus at a stage of manufacture in accordance with an embodiment.
FIG. 3 illustrates, in a simplified cross-sectional view, an alternative example semiconductor device apparatus having an aging sensor system at a stage of manufacture in accordance with an embodiment.
FIG. 4 illustrates, in a simplified bottom-side-up plan view, the alternative example semiconductor device apparatus at a stage of manufacture in accordance with an embodiment.
FIG. 5 illustrates, in a simplified block diagram schematic view, an example system for monitoring aging of a semiconductor device in accordance with an embodiment.

### Detailed Description

Generally, there is provided, a packaged semiconductor device having an aging sensor system. The semiconductor device includes a semiconductor die encapsulated with an encapsulant. The aging sensor includes a capacitor having a first plate integrated at a bottom side of the semiconductor device and a second plate integrated at a top side of a substrate that the semiconductor device is mounted on. The semiconductor die includes a capacitance measurement circuit interconnected to the first plate of the capacitor. As the semiconductor device ages, mechanical stress applied to transistors and/or electromechanical features of the semiconductor die may change thus affecting characteristics of the semiconductor device. As the package warps, the first plate deforms and causes changes in the capacitance value of the capacitor. By monitoring the capacitance of the capacitor and corresponding temperature of the semiconductor device, an amount of aging may be determined for dynamically trimming or calibrating sensitive circuitry and electromechanical features affected by mechanical stress.

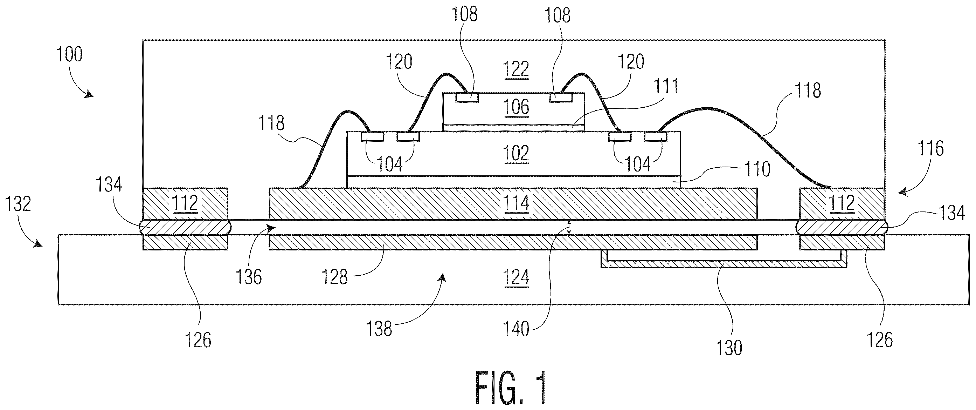

FIG. 1 illustrates, in a simplified cross-sectional view, an example semiconductor device apparatus having an aging sensor system at a stage of manufacture in accordance with an embodiment. At this stage, the semiconductor device apparatus includes a packaged semiconductor device 100 mounted on a substrate 132.

In this embodiment, the packaged semiconductor device 100 includes a first semiconductor die 102 and a second semiconductor die 106 configured in a stacked-die arrangement mounted on a package leadframe 116 and encapsulated with an encapsulant 122. The leadframe 116 includes a plurality of leads 112 substantially surrounding a die pad 114. The leadframe 116 may be formed from a suitable conductive metal material, such as copper, silver, nickel, aluminum, or iron, or alloys thereof, for example. The term "conductive," as used herein, generally refers to the property of electrical conductivity unless otherwise noted. Even though the leadframe 116 may be characterized as a quad flat no-lead (QFN) type leadframe, embodiments with other package leadframe types and configurations are anticipated by this disclosure. The semiconductor die 102 is affixed on the die pad 114 of the leadframe 116 by way of a die attached adhesive 110 and the semiconductor die 106 is affixed on the semiconductor die 102 by way of a die attach adhesive 111, for example. Bond wires 118 are configured to interconnect bond pads 104 of the semiconductor die 102 with leads 112 and die pad 114 of the leadframe 116, and bond wires 120 are configured to interconnect bond pads 108 of the semiconductor die 106 with bond pads 104 of the semiconductor die 102 and leads 112 of the leadframe 116. The encapsulant 122 encapsulates the semiconductor die 102 and 106 and a portion of the leadframe 108. The encapsulant 122 may be an epoxy molding compound dispensed during an injection molding encapsulation operation, for example. In this embodiment, the bottom side of the die pad 114 and the bottom and outer sides of the leads 112 are exposed through the encapsulant 122. The die pad 114 in this embodiment is configured as a first plate of an aging sensor capacitor 138 formed at the bottom side of the packaged semiconductor device 100. The first plate 114 of the aging sensor capacitor 138 is connected with a bond pad 104 of the semiconductor die 102 by way of a bond wire 118, for example.

The semiconductor die 102 has an active side (e.g., major side having circuitry, bond pads) and a backside (e.g., major side opposite of the active side). The semiconductor die 102 includes bond pads 104 located at the active side of the semiconductor die. In this embodiment, the semiconductor die 102 is in an active-side-up orientation with the backside affixed to the die pad 114. The semiconductor die 102 may be formed from any suitable semiconductor material, such as silicon, germanium, gallium arsenide, gallium nitride, and the like. The semiconductor die 102 may further include any digital circuits, analog circuits, RF circuits, sensors, memory, processor, the like, and combinations thereof at the active side.

The semiconductor die 106 has an active side (e.g., major side having circuitry, bond pads) and a backside (e.g., major side opposite of the active side). The semiconductor die 106 includes bond pads 108 located at the active side. In this embodiment, the semiconductor die 106 is in an active-side-up orientation with the backside affixed to the active side of the semiconductor die 102. The semiconductor die 106 may be formed from any suitable semiconductor material, such as silicon, germanium, gallium arsenide, gallium nitride, and the like. The semiconductor die 106 may further include any digital circuits, analog circuits, RF circuits, micro-electromechanical systems (MEMS), sensors, memory, processor, the like, and combinations thereof at the active side.

In this embodiment, the stacked-die arrangement of the semiconductor die 102 and the semiconductor die 106 may be characterized as a sensor system. The sensor system may include the semiconductor die 102 configured as a controller subsystem and the semiconductor die 106 configured as a MEMS sensor, for example. Circuitry and/or electromechanical features of the semiconductor die of the sensor system may be sensitive to changes in mechanical (e.g., package) stress associated with aging of the packaged semiconductor device 100.

The substrate 132 may be formed from a non-conductive laminate material 124 (e.g., FR4) with embedded conductive features 126-130 (e.g., copper traces, vias), for example. The substrate 132 may be characterized as a printed circuit board (PCB), interposer, or another package substrate, for example. In this embodiment, the substrate 132 includes a plurality of substrate pads 126 and a second plate 128 of the aging sensor capacitor 138 exposed at a top side of the substrate. A conductive trace 130 is configured to interconnect the second plate 128 with at least one of the substrate pads 126. In some embodiments, the conductive trace 130 is configured to interconnect the second plate 128 with a substrate pad 126 configured as a ground voltage supply terminal. The packaged semiconductor device 100 is mounted on the substrate 132 by way of a solder material 134 disposed between the exposed leads 112 at the bottom of the packaged semiconductor device 100 and the exposed substrate pads 126 at the top of the substrate 132. The solder material 134 may be in the form of a solder paste configured to form a conductive connection between the leads 112 of the packaged semiconductor device 100 and the substrate pads 126 of the substrate 132 during a reflow operation, for example. In this embodiment, an air gap 136 is formed between the plates 114 and 128 of the aging sensor capacitor 138 when the packaged semiconductor device 100 is mounted on the substrate 132. In some embodiments, the air gap 136 may be filled with a suitable capacitor dielectric material.

In this embodiment, the aging sensor capacitor 138 is formed as a parallel plate capacitor having a top plate 114 at the bottom side of the packaged semiconductor device 100 separated from a bottom plate 128 at the top side of the substrate 132 by a predetermined vertical distance 140. As the age of the packaged semiconductor device 100 increases, the encapsulant 122 may continue to cure over time causing the packaged semiconductor device 100 to warp. Such package warpage may be identified by way of changes in measured capacitance of the aging sensor capacitor 138, for example. The terms "age" and "amount of aging," as used herein, generally refers to the elapsed time (e.g., weeks, months, years) from the approximate date of manufacture of the packaged semiconductor device.

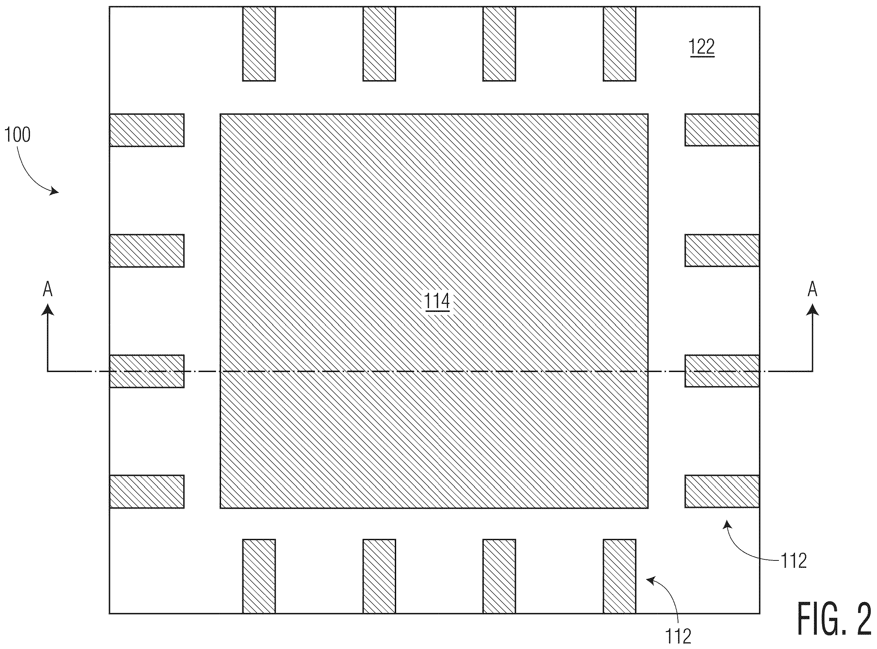

FIG. 2 illustrates, in a simplified bottom-side-up plan view, the example semiconductor device apparatus at a stage of manufacture in accordance with an embodiment. In this embodiment, the bottom side of the packaged semiconductor device 100 is depicted prior to mounting on the substrate 132 of FIG. 1. The backside of the die pad 114 and the leads 112 of the leadframe are exposed through the bottom side of the encapsulant 122. The exposed leads 112 are distributed around an outer perimeter of the encapsulated semiconductor device 100 and substantially surround the exposed backside of the die pad 114. In this embodiment, the die pad 114 is configured as one of the plates of the aging sensor capacitor 138 of FIG. 1. The number and arrangement of the leads 112 and the die pad 114 in this embodiment are chosen for illustration purposes. The simplified cross-sectional view of the semiconductor device 100 mounted on the substrate 132 as depicted in FIG. 1 is taken along line A-A, for example.

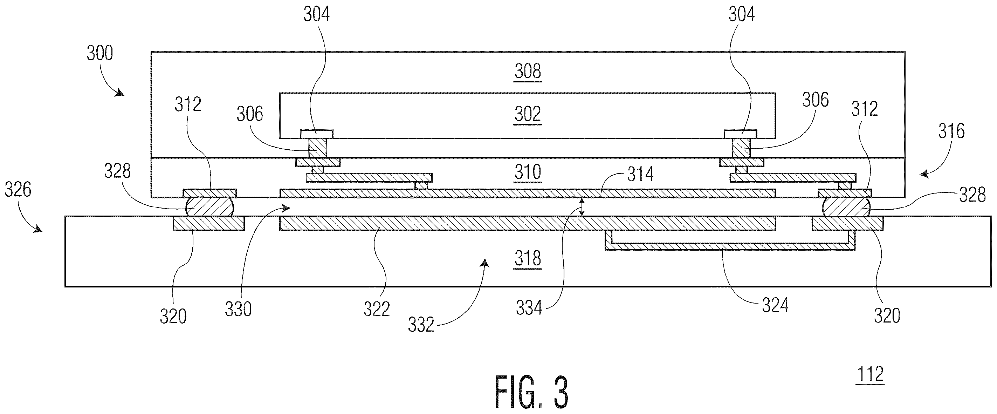

FIG. 3 illustrates, in a simplified cross-sectional view, an alternative example semiconductor device apparatus having an aging sensor system at a stage of manufacture in accordance with an embodiment. At this stage, the alternative semiconductor device apparatus includes a packaged semiconductor device 300 mounted on a substrate 326. In this embodiment, the packaged semiconductor device 300 includes a semiconductor die 302 encapsulated with an encapsulant 308 (e.g., epoxy molding compound) and an interconnecting package substrate 316 applied at a bottom side. The semiconductor die 302 has an active side (e.g., major side having circuitry) and a backside (e.g., major side opposite of the active side). The semiconductor die 302 includes bond pads 304 formed at the active side. In this embodiment, semiconductor die 302 is configured in an active-side-down orientation. The semiconductor die 302 may be formed from any suitable semiconductor material, such as silicon, germanium, gallium arsenide, gallium nitride, and the like. The semiconductor die 102 may further include any digital circuits, analog circuits, RF circuits, sensors, memory, processor, the like, and combinations thereof at the active side. Circuitry and/or electromechanical features of the semiconductor die 302 may be sensitive to mechanical (e.g., package) stress associated with aging of the encapsulant 308, for example. In this embodiment, conductive die connectors 306 have a first end affixed to respective bond pads 304 and a second end exposed through the bottom side of the encapsulant (prior to the package substrate 316 being applied). The conductive die connectors 306 may be in the form of suitable conductive structures such as gold studs, copper pillars, solder balls, and the like.

The package substrate 316 is applied at the bottom side of the encapsulant 308 encapsulating the semiconductor die 302. The package substrate 316 includes conductive features (e.g., copper connection pads 312, first capacitor plate 314, interconnecting traces and vias) surrounded by non-conductive material 310 (e.g., dielectric). The package substrate 316 is formed as a redistribution structure configured to interconnect the semiconductor die 302 with the substrate 326. The first plate 314 of the aging sensor capacitor 332 is connected with a bond pad 304 of the semiconductor die 302 by way of the die connectors 306 and conductive features of the package substrate 316, for example. The package substrate 316 may be formed as a build-up substrate or may be provided as a preformed substrate. The connection pads 312 of the package substrate 316 substantially surround the first capacitor plate 314 of an aging sensor capacitor 332 in this embodiment. In this embodiment, the bottom side of the first capacitor plate 314 and bottom portions of the connection pads 312 are exposed at the bottom side of the package substrate 316. Even though the package substrate 326 of the packaged semiconductor device 300 may be characterized as a ball grid array (BGA) type package substrate, embodiments with other package substrate types and configurations are anticipated by this disclosure.

The substrate 326 may be formed from a non-conductive laminate material 318 (e.g., FR4) with embedded conductive features 320-324 (e.g., copper traces, vias), for example. The substrate 326 may be characterized as a PCB, interposer, or another package substrate, for example. In this embodiment, the substrate 326 includes a plurality of substrate pads 320 and a second plate 322 of the aging sensor capacitor 332 exposed at a top side of the substrate. A conductive trace 324 is configured to interconnect the second plate 322 with at least one of the substrate pads 320. In some embodiments, the conductive trace 324 is configured to interconnect the second plate 322 with a substrate pad 320 configured as a ground voltage supply terminal. The packaged semiconductor device 300 is mounted on the substrate 326 by way of a package connectors 328 disposed between the exposed connection pads 312 at the bottom of the packaged semiconductor device 300 and the exposed substrate pads 320 at the top of the substrate 326. The package connectors 328 may be in the form of solder balls or solder paste configured to form a conductive connection between the pads 312 of the packaged semiconductor device 300 and the substrate pads 320 of the substrate 326 during a reflow operation, for example. In this embodiment, an air gap 330 is formed between the plates 314 and 322 of the aging sensor capacitor 332 when the packaged semiconductor device 300 is mounted on the substrate 326. In some embodiments, the air gap 330 may be filled with a suitable capacitor dielectric material.

In this embodiment, the aging sensor capacitor 332 is formed as a parallel plate capacitor having a top plate 314 at the bottom side of the packaged semiconductor device 300 separated from a bottom plate 322 at the top side of the substrate 326 by a predetermined vertical distance 334. As the age of the packaged semiconductor device 300 increases, the encapsulant 308 may continue to cure over time causing the packaged semiconductor device 300 to slightly warp. Such package warpage may be identified by way of changes in measured capacitance of the aging sensor capacitor 332, for example.

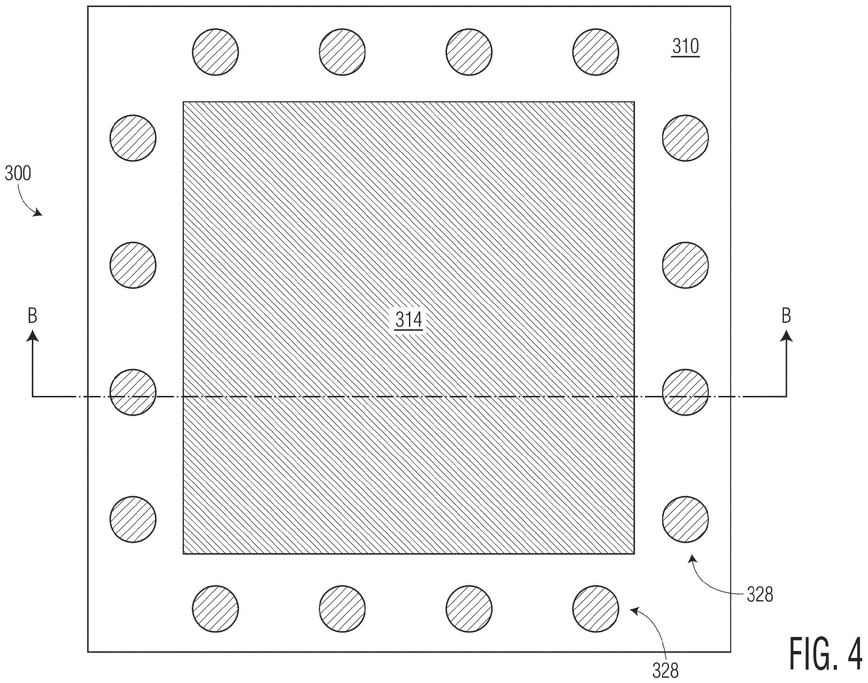

FIG. 4 illustrates, in a simplified bottom-side-up plan view, the example semiconductor device apparatus at a stage of manufacture in accordance with an embodiment. In this embodiment, the bottom side of the packaged semiconductor device 300 is depicted prior to mounting on the substrate 326 of FIG. 3. The exposed first capacitor plate 314 of the aging sensor capacitor 332 of FIG. 3 and package connectors 328 are depicted at the bottom side of the packaged semiconductor device 300. The package connectors 328 are distributed around an outer perimeter of the encapsulated semiconductor device 300 and substantially surround the exposed first capacitor plate 314. The number and arrangement of the package connectors 328 and the first capacitor plate 314 in this embodiment are chosen for illustration purposes. The simplified cross-sectional view of the semiconductor device 300 mounted on the substrate 326 as depicted in FIG. 3 is taken along line B-B, for example.

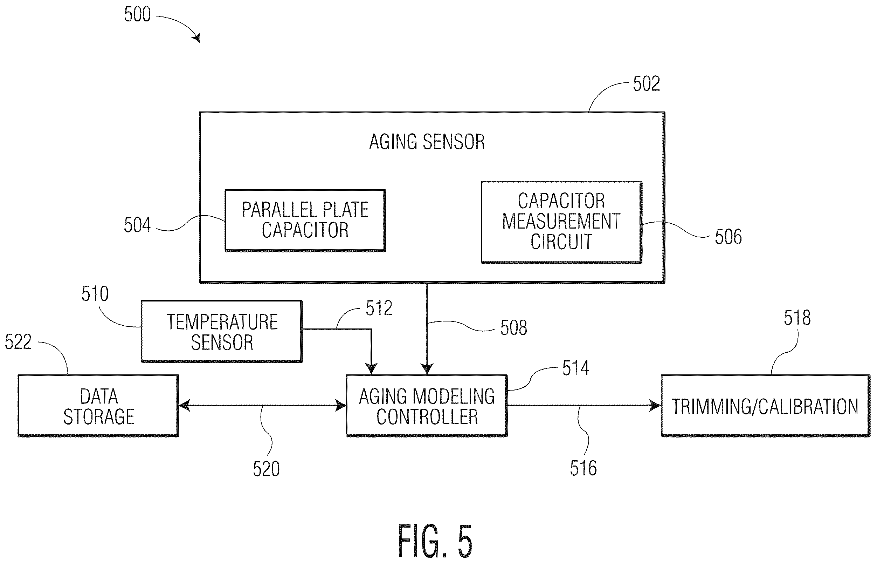

FIG. 5 illustrates, in a simplified block diagram schematic view, example system circuitry 500 for monitoring aging of a packaged semiconductor device in accordance with an embodiment. In this embodiment, the aging system 500 includes an aging sensor 502, a temperature sensor 510, an aging modeling controller 514, a trimming/calibration unit 518, and a data storage unit 522. The aging sensor 502 includes a parallel plate capacitor 504 and a capacitor measurement circuit 506. For discussion purposes, the capacitor measurement circuit 506, temperature sensor 510, aging modeling controller 514, trimming/calibration unit 518, and data storage unit 522 may be integrated within the semiconductor die 102 and 302 of the respective packaged semiconductor devices 100 and 300 depicted in FIGs. 1 and 3.

The parallel plate capacitor 504 of the aging sensor 502 includes a first plate integrated within the packaged semiconductor device and a second plate integrated within a substrate that the packaged semiconductor device is mounted on. For example, the parallel plate capacitor 504 may correspond to the aging sensor capacitor 138 of FIG. 1 and aging sensor capacitor 332 of FIG. 3. Each of the aging sensor capacitors 138 and 332 are interconnected to respective semiconductor die 102 and 302. As the age of the packaged semiconductor device increases, the encapsulant of the packaged semiconductor device may cause the packaged semiconductor device to warp. For example, the encapsulant may continue to cure due to oxidation and/or UV light exposure factors over time. Differences in coefficient of thermal expansion (CTE) of the packaged semiconductor device (e.g., semiconductor die, encapsulant) may further contribute to the warpage as the temperature of the packaged semiconductor device changes. The warpage of the packaged semiconductor device may change mechanical stress on circuitry and/or electromechanical features of the semiconductor die of the packaged semiconductor device.

The warpage of the packaged semiconductor device directly affects the physical properties of the parallel plate capacitor 504 such as the distance between the plates across the dielectric (e.g., air gap). For example, the warpage of the packaged semiconductor device changes the contour of the first plate (of the parallel plate capacitor 504) integrated within the packaged semiconductor device. Accordingly, the changes in the contour of the first plate due to the warpage of the packaged semiconductor device is detectable and measurable by way of corresponding changes in capacitance of the parallel plate capacitor 504.

The capacitor measurement circuit 506 of the aging sensor 502 is coupled to the parallel plate capacitor 504 and configured to measure capacitance of the parallel plate capacitor 504. The capacitor measurement circuit 506 may include circuitry configured to measure capacitance by way of known techniques. For example, the capacitor measurement circuit 506 may be configured to couple the parallel plate capacitor 504 to an oscillator circuit whereby a resulting frequency corresponds to the capacitance of the parallel plate capacitor 504. Accordingly, the capacitance of the parallel plate capacitor 504 is determined by way of the resulting frequency. The capacitor measurement circuit 506 may be coupled to the parallel plate capacitor 504 by way of switch circuitry such that the capacitance of the parallel plate capacitor 504 may be selectively or periodically sampled. The aging sensor output 508 may include the measured capacitance of the parallel plate capacitor 504 or may include information from which the capacitance of the parallel plate capacitor 504 can be determined, such as a measured frequency from an oscillator circuit for example.

The temperature sensor 510 of the aging system 500 includes circuitry configured to measure temperature of the packaged semiconductor device. In some embodiments, the temperature sensor 510 may be formed as multiple temperature sensors distributed across the semiconductor die of the packaged semiconductor device such that an average temperature of the packaged semiconductor device can be determined. In some embodiments, the temperature sensor 510 may be located near sensitive circuitry of the semiconductor die of the packaged semiconductor device. The temperature sensor output 512 may include the measured temperature of the packaged semiconductor device or may include information which is representative of the measured temperature of the packaged semiconductor device, for example.

The aging modeling controller 514 of the aging system 500 is coupled to the aging sensor 502 and the temperature sensor 510 and receives the aging sensor output 508 and the temperature sensor output 512. The aging modeling controller 514 is configured to determine an amount of aging of a packaged semiconductor device based on the aging sensor output 508 and the temperature sensor output 512. For example, the aging modeling controller 514 may include an aging model for the relationship between the packaged semiconductor device age (e.g., aging state of the encapsulant) and the capacitance value of the parallel plate capacitor 504 and corresponding measured temperature of the packaged semiconductor device. By simultaneously measuring the temperature of the packaged semiconductor device and the capacitance of the parallel plate capacitor 504, the aging state of the encapsulant (e.g., mold compound) may be determined. The aging modeling controller 514 may be configured to monitor the capacitance values of the aging sensor 502 and temperature values of the temperature sensor 510 on a periodic basis, during interrupts, reboots, or power-on events of the packaged semiconductor device, for example. The aging modeling controller output 516 may be provided to other systems (e.g., trimming/calibration unit 518) which can adjust one or more operating parameters or perform an operation based on the controller output 516. The aging modeling controller output 516 may include the determined amount of aging of the packaged semiconductor device, the aging state of the encapsulant, or may include information which is representative of the amount of aging of the packaged semiconductor device, for example.

The trimming/calibration unit 518 of the aging system 500 is coupled to the aging modeling controller 514 and receives the aging modeling controller output 516. The trimming/calibration unit 518 includes circuitry configured to apply an amount of trimming and/or calibration adjustments for sensitive circuitry and/or electromechanical features of the packaged semiconductor device based on the controller output 516. For example, the trimming/calibration unit 518 may adjust (e.g., trim) parameters of circuit elements to compensate for frequency drift of a clock generation circuit impacted by mechanical stress as the package encapsulant ages. The trimming/calibration unit 518 may be further configured to apply the trimming and/or calibration adjustments periodically or during an interrupt, reboot, or power-on event of the packaged semiconductor device, for example.

The data storage unit 522 of the aging system 500 is coupled to the aging modeling controller 514. In this embodiment, the data storage unit 522 and the aging modeling controller 514 are configured for bidirectional communication over bus 520. For example, the data storage unit 522 may be used to store instructions and/or data received from aging modeling controller 514 by way of bus 520. The aging modeling controller 514 may retrieve historical data (e.g., temperature and capacitance measurements) from the data storage unit 522 by way of bus 520 to update the aging model relationship between the packaged semiconductor device age and the capacitance value of the parallel plate capacitor 504 and corresponding measured temperature of the packaged semiconductor device. The data storage unit 522 may include one or more non-volatile memory arrays, for example.

Generally, there is provided, an apparatus including a packaged semiconductor device including; a semiconductor die including a controller configured to obtain a measured capacitance of a sensor capacitor, an encapsulant encapsulating the semiconductor die, and a first plate of the sensor capacitor formed at a bottom side of the packaged semiconductor device; and a substrate including a second plate of the sensor capacitor formed at a top side of the substrate, the packaged semiconductor device mounted on the top side of the substrate. The sensor capacitor may be characterized as a parallel plate capacitor, the first plate separated from the second plate by an air gap. The controller may be further configured to determine an amount of aging based on the measured capacitance of the sensor capacitor. The semiconductor die may further include a temperature sensor coupled to the controller, the controller may be further configured to determine the amount of aging based on the measured capacitance of the sensor capacitor and measured temperature. The semiconductor die may further include a capacitor measurement circuit configured to measure capacitance of the sensor capacitor, the capacitor measurement circuit coupled to provide the measured capacitance to the controller. The packaged semiconductor device may further include a leadframe having plurality of leads substantially surrounding a die pad, the semiconductor die mounted on the die pad. The die pad of the leadframe may be configured as the first plate of the sensor capacitor. A first bond pad of the semiconductor die may be interconnected with the first plate of the sensor capacitor, and a second bond pad of the semiconductor die may be interconnected with the second plate of the sensor capacitor. The semiconductor die may further include a memory configured to store historical capacitance data of the sensor capacitor, the controller further configured to determine the amount of aging based on the historical capacitance data.

In another embodiment, there is provided, a method including measuring capacitance of a sensor capacitor, a first plate of the sensor capacitor included at a bottom side of a packaged semiconductor device, a second plate of the sensor capacitor included at a top side of a substrate, the packaged semiconductor device mounted on the top side of the substrate; and determining, by way of a controller, an amount of aging of the packaged semiconductor device based on the measured capacitance of the sensor capacitor. The sensor capacitor may be characterized as a parallel plate capacitor, the first plate separated from the second plate by an air gap between the packaged semiconductor device and the substrate. The packaged semiconductor device may include a leadframe having a die pad, the die pad of the leadframe configured as the first plate of the sensor capacitor. The method may further include storing, in a memory, historical capacitance data of the sensor capacitor, and determining the amount of aging of the packaged semiconductor device based on the historical capacitance data. A semiconductor die of the packaged semiconductor device may be interconnected with the first plate of the sensor capacitor and the second plate of the sensor capacitor. The method may further include measuring a temperature of the packaged semiconductor device by way of a temperature sensor coupled to the controller and wherein determining the amount of aging of the packaged semiconductor device is based on the measured capacitance of the sensor capacitor and the measured temperature.

In yet another embodiment, there is provided, an apparatus including a packaged semiconductor device including: a semiconductor die including a controller configured to obtain a measured capacitance of a parallel plate sensor capacitor and determine an amount of aging based on the measured capacitance of the sensor capacitor, an encapsulant encapsulating the semiconductor die, and a first plate of the sensor capacitor formed at a bottom side of the packaged semiconductor device; and a substrate including a second plate of the sensor capacitor formed at a top side of the substrate, the packaged semiconductor device mounted on the top side of the substrate. The semiconductor die may further include a temperature sensor coupled to the controller, the controller may be further configured to determine the amount of aging based on the measured capacitance of the sensor capacitor and measured temperature. The semiconductor die may further include a capacitor measurement circuit configured to measure capacitance of the sensor capacitor, the capacitor measurement circuit coupled to provide the measured capacitance to the controller. The packaged semiconductor device may further include the semiconductor die mounted on a die pad of a leadframe, the die pad of the leadframe configured as the first plate of the sensor capacitor. A first bond pad of the semiconductor die may be interconnected with the first plate of the sensor capacitor, and a second bond pad of the semiconductor die may be interconnected with the second plate of the sensor capacitor.

By now it should be appreciated that there has been provided, a packaged semiconductor device having an aging sensor system. The semiconductor device includes a semiconductor die encapsulated with an encapsulant. The aging sensor includes a capacitor having a first plate integrated at a bottom side of the semiconductor device and a second plate integrated at a top side of a substrate that the semiconductor device is mounted on. The semiconductor die includes a capacitance measurement circuit interconnected to the first plate of the capacitor. As the semiconductor device ages, mechanical stress applied to transistors and/or electromechanical features of the semiconductor die may change thus affecting characteristics of the semiconductor device. As the package warps, the first plate deforms and causes changes in the capacitance value of the capacitor. By monitoring the capacitance of the capacitor and corresponding temperature of the semiconductor device, an amount of aging may be determined for dynamically trimming or calibrating sensitive circuitry and electromechanical features affected by mechanical stress.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. An apparatus comprising:
a packaged semiconductor device including:
a semiconductor die including a controller configured to obtain a measured capacitance of a sensor capacitor,
an encapsulant encapsulating the semiconductor die, and
a first plate of the sensor capacitor formed at a bottom side of the packaged semiconductor device; and
a substrate including a second plate of the sensor capacitor formed at a top side of the substrate, the packaged semiconductor device mounted on the top side of the substrate.

2. The apparatus of claim 1, wherein the sensor capacitor is characterized as a parallel plate capacitor, the first plate separated from the second plate by an air gap.

3. The apparatus of claim 1 or claim 2, wherein the controller is further configured to determine an amount of aging based on the measured capacitance of the sensor capacitor.

4. The apparatus of claim 3, wherein the semiconductor die further includes a temperature sensor coupled to the controller, the controller further configured to determine the amount of aging based on the measured capacitance of the sensor capacitor and measured temperature.

5. The apparatus according to any preceding claim, wherein the semiconductor die further includes a capacitor measurement circuit configured to measure capacitance of the sensor capacitor, the capacitor measurement circuit coupled to provide the measured capacitance to the controller.

6. The apparatus according to any preceding claim, wherein the packaged semiconductor device further includes a leadframe having plurality of leads substantially surrounding a die pad, the semiconductor die mounted on the die pad.

7. The apparatus of claim 6, wherein the die pad of the leadframe is configured as the first plate of the sensor capacitor.

8. The apparatus according to any preceding claim, wherein a first bond pad of the semiconductor die is interconnected with the first plate of the sensor capacitor, and wherein a second bond pad of the semiconductor die is interconnected with the second plate of the sensor capacitor.

9. The apparatus according to any preceding claim, wherein the semiconductor die further includes a memory configured to store historical capacitance data of the sensor capacitor, the controller further configured to determine the amount of aging based on the historical capacitance data.

10. A method comprising:
measuring capacitance of a sensor capacitor, a first plate of the sensor capacitor included at a bottom side of a packaged semiconductor device, a second plate of the sensor capacitor included at a top side of a substrate, the packaged semiconductor device mounted on the top side of the substrate; and
determining, by way of a controller, an amount of aging of the packaged semiconductor device based on the measured capacitance of the sensor capacitor.

11. The method of claim 10, wherein the sensor capacitor is characterized as a parallel plate capacitor, the first plate separated from the second plate by an air gap between the packaged semiconductor device and the substrate.

12. The method of claim 10 or claim 11, wherein the packaged semiconductor device includes a leadframe having a die pad, the die pad of the leadframe configured as the first plate of the sensor capacitor.

13. The method according to any of claims 10 to 12, further comprising storing, in a memory, historical capacitance data of the sensor capacitor, and determining the amount of aging of the packaged semiconductor device based on the historical capacitance data.

14. The method according to any of claims 10 to 13wherein a semiconductor die of the packaged semiconductor device is interconnected with the first plate of the sensor capacitor and the second plate of the sensor capacitor.

15. The method according to any of claims 10 to 14, further comprising measuring a temperature of the packaged semiconductor device by way of a temperature sensor coupled to the controller and wherein determining the amount of aging of the packaged semiconductor device is based on the measured capacitance of the sensor capacitor and the measured temperature.
